# EUROPEAN PATENT SPECIFICATION

(11) **EP 2 677 848 B1**
(45) Date of publication and mention of the grant of the patent: **04.01.2017**
(21) Application number: 12834576.6
(22) Date of filing: 29.10.2012
(51) Int. Cl.: H05K 7/20, F24F 1/02, F28D 15/02, F28F 27/00, F25B 1/00, F28D 1/053, F28D 15/06, F28D 21/00

(54) **HEAT EXCHANGER AND CABINET**
WÄRMETAUSCHER UND KAMMER DAFÜR
ECHANGEUR THERMIQUE ET ARMOIRE

(30) Priority: 13.03.2012 CN 201210065156
(43) Date of publication of application: 25.12.2013
(73) Proprietor: Huawei Technologies Co., Ltd., Longgang District Shenzhen, Guangdong 518129 (CN)
(72) Inventor: WANG, Tao, Shenzhen Guangdong 518129 (CN)
(74) Representative: Thun, Clemens
(86) International application number: PCT/CN2012/083670
(87) International publication number: WO 2013/135048

(56) References cited:
- WO-A2-2008/128311
- CN-A- 101 196 325
- CN-A- 101 871 740
- CN-A- 102 486 324
- CN-U- 201 733 563
- CN-U- 201 750 670
- CN-Y- 2 369 006
- JP-A- 2007 234 791

## Description

### FIELD OF THE INVENTION

The present invention relates to the field of mechanical and electrical technologies, and in particular, to a heat exchanger and a cabinet.

### BACKGROUND OF THE INVENTION

Each device has certain requirements on an environment thereof in a working process, and if the temperature of the device in the working process is too high, the working efficiency and reliability of the device may be affected. Therefore, many devices need heat exchangers to conduct the heat out of the devices, so that the devices can work in a proper temperature to ensure their working efficiency and reliability. Therefore, heat exchangers are widely applied.

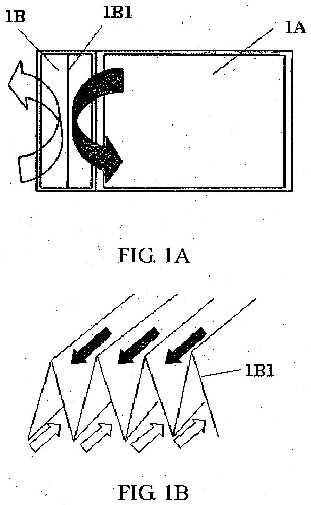

Taking a communication base station as an example, a heat exchanger usually adopted for heat dissipation of a high-power cabinet may be a heat exchanger/heat exchanger (HEX, Heat Exchanger) or the heat dissipation is implemented by using the heat exchange capability of an air conditioner. The high-power cabinet of the communication base station generally adopts a form of a heat exchanger or a communication cabinet air conditioner to keep a communication device isolated from the outside to meet the IP55 level requirement of the communication device; therefore, when the heat dissipation is ensured, the communication device can be kept isolated from the outside, so that the IP55 level of the device and reliability requirements of components inside the communication device can be satisfied. FIG. 1A is a schematic diagram of a heat dissipation structure of a high-power cabinet, including: a communication device chassis 1A and a heat exchanger 1B. The heat exchanger 1B has a partition board 1B1 to isolate air in the communication device chassis 1A from air outside. FIG. 1B is a schematic structural diagram of a heat exchange principle. In FIG. 1A and FIG. 1B, the directions indicated by black arrows are flow directions of the air in the communication device chassis 1A (where a part in a radiator is referred to as an internal circulation air duct (a first air duct 300)), the directions indicated by white arrows are flow directions of the air outside the communication device chassis 1A (where a part in the radiator is referred to as an external circulation air duct), and the heat exchange of the air in and outside the communication device chassis 1A is performed in the heat exchanger 1B. The air flows and implements the internal and external air ducts through a fan. The internal circulation air duct (the first air duct 300) (300) and the external circulation air duct 400 that are isolated by a partition board (200) have the partition board 1B1 in the heat exchanger 1B to isolate the air in the communication device chassis 1A from the air outside.

The plate heat exchanger shown in FIG. 1A and FIG. 1B has high flow resistance. With the increase of the power of the cabinet, the plate heat exchanger has low heat exchange efficiency and gradually fails to meet an application requirement. Base on this, an enhanced heat dissipation solution is proposed, where a heat exchanger having an air conditioner is universally applied.

The heat exchanger having an air conditioner generally includes: an evaporative cooler, a condensation radiator, and a compressor. The evaporative cooler and the condensation radiator are connected through a pipeline to form a closed loop. The compressor is located in the pipeline in the closed loop. When the compressor works, a fluid flows in the closed loop from the condensation radiator to the evaporative cooler, then flows from the evaporative cooler to the compressor, and finally flows from the compressor to the condensation radiator to form a fluid cycle.

For the heat exchanger having an air conditioner, the air conditioner has a strong heat dissipation capability when the compressor is in a working state, and the air conditioner has no heat dissipation capability when the compressor stops working. As the heat dissipation function based on the heat exchanger requires the compressor to work for a long time, quick consumption of the compressor is caused, and a short service life of the heat exchanger is further resulted. In addition, the compressor has high power consumption after working for a long time. CN 101 871 740 A discloses a heat exchanger, a heat dissipation method for the heat exchanger and communication equipment. CN 101 196 325 A discloses an energy-saving air conditioner. CN 2 369 006 Y discloses a heating belt for a compressor. CN 201 733 563 U discloses an air-conditioning system suitable for cabinets.

### SUMMARY OF THE INVENTION

Embodiments of the present invention provide a heat exchanger and a cabinet, to improve heat exchange efficiency.

A heat exchanger includes: a first air duct and a second air duct, where the first air duct and the second air duct are isolated from each other, the first air duct is set with a first heat exchange unit, and the second air duct is set with a second heat exchange unit;
the first heat exchange unit includes: a first heat pipe heat exchanger and an evaporative cooler; and the second heat exchange unit includes: a second heat pipe heat exchanger and a condensation radiator;
a cavity of the first heat pipe heat exchanger is connected to a cavity of the second heat pipe heat exchanger through a first pipeline, so that a first closed loop is formed between the cavity of the first heat pipe heat exchanger and the cavity of the second heat pipe heat exchanger;
a cavity of the evaporative cooler is connected to a cavity of the condensation radiator through a second pipeline, so that a second closed loop is formed between the cavity of the evaporative cooler and the cavity of the condensation radiator; and
the first closed loop and the second closed loop each contain a fluid capable of carrying heat; and
the heat exchanger further includes: a compressor and a first valve, where
the compressor is set in the second pipeline through which the fluid flows from the evaporative cooler to the condensation radiator, an inlet of the compressor is connected to the evaporative cooler through the second pipeline, and an outlet of the compressor is connected to the condensation radiator through the second pipeline; and the first valve is set in the second pipeline between the inlet of the compressor and the evaporative cooler; and
when the temperature of the first heat pipe heat exchanger side is higher than a first target temperature, the first valve is opened, and the compressor is turned on so that the compressor is in a working state; when the temperature of the first heat pipe heat exchanger side is lower than a second target temperature, the first valve is closed, and the compressor is turned off so that the compressor is in an non-working state, where both the first target temperature and the second target temperature are lower than or equal to an ambient temperature needed by a heat source to work normally, and the first target temperature is higher than or equal to the second target temperature.

A cabinet includes: an internal side of the cabinet and an external side of the cabinet, where the internal side of the cabinet is a side installed with a heat source component, and the external side of the cabinet is space outside the cabinet; and further includes: any heat exchanger provided by the embodiments of the present invention, and the first air duct of the heat exchanger is located at the internal side of the cabinet, the second air duct is located at the external side of the cabinet; the first heat exchange unit of the heat exchanger is located below the second heat exchange unit.

It can be seen from the above technical solutions that, the embodiments of the present invention have the following advantages: when an actual control temperature is higher than the first target temperature, the first valve is opened so that the compressor is in a working state, to implement enhanced heat dissipation; when an actual control temperature is lower than the second target temperature, the first valve is closed so that the compressor is in an non-working state, and at this time, the heat pipe heat exchanger is still in a working state and also achieves a desired heat heat exchanger 4011;
a cavity of the evaporative cooler 3012 is connected to a cavity of the condensation radiator 4012 through a second pipeline 502, so that a second closed loop is formed between the cavity of the evaporative cooler 3012 and the cavity of the condensation radiator 4012; and
the first closed loop and the second closed loop each contain a fluid capable of carrying heat; and
the heat exchanger further includes: a compressor 5021 and a first valve 5024, where
the compressor 5021 is set in the second pipeline 502 through which the fluid flows from the evaporative cooler 3012 to the condensation radiator 4012, an inlet of the compressor 5021 is connected to the evaporative cooler 3012 through the second pipeline 502, and an outlet of the compressor 5021 is connected to the condensation radiator 4012 through the second pipeline 502; and the first valve 5024 is set in the second pipeline 502 between the inlet of the compressor 5021 and the evaporative cooler 3012; and
when the temperature of the first heat pipe heat exchanger 3011 side is higher than a first target temperature, the first valve 5024 is opened, and the compressor 5021 is turned on so that the compressor 5021 is in a working state; when the temperature of the first heat pipe heat exchanger 3011 side is lower than a second target temperature, the first valve 5024 is closed, and the compressor 5021 is turned off so that the compressor 5021 is in an non-working state, where both the first target temperature and the second target temperature are lower than or equal to an ambient temperature needed by a heat source to work normally, and the first target temperature is higher than or equal to the second target temperature.

A cabinet includes: an internal side of the cabinet and an external side of the cabinet, where the internal side of the cabinet is a side installed with a heat source component, and the external side of the cabinet is space outside the cabinet; and further includes: any heat exchanger provided by the embodiments of the present invention, and the first air duct 300 of the heat exchanger is located at the internal side of the cabinet, the second air duct 400 is located at the external side of the cabinet; the first heat exchange unit 301 of the heat exchanger is located below the second heat exchange unit 401.

It can be seen from the above technical solutions that, the embodiments of the present invention have the following advantages: when an actual control temperature is higher than the target temperature, the first valve is opened so that the compressor is in a working state, to implement enhanced heat dissipation; when an actual control temperature is lower than the second target temperature, the first valve is closed so that the compressor is in an non-working state, and at this time, the heat pipe heat exchanger is still in a working state and also achieves a desired heat dissipation capability. Therefore, with the technical solutions of the embodiments of the present invention, hierarchical heat dissipation can be implemented to meet heat dissipation requirements of different intensities, and in the condition that the heat dissipation capability is ensured, the compressor is turned off, which may reduce the working time of the compressor, thereby reducing power consumption to save energy, and reducing consumption of the compressor to prolong the service life of the heat exchanger.

### BRIEF DESCRIPTION OF THE DRAWINGS

To describe the technical solutions in the embodiments of the present invention more clearly, the following briefly introduces the accompanying drawings required for describing the embodiments. Apparently, the accompanying drawings in the following description show merely some of the embodiments of the present invention, and persons of ordinary skill in the art may still derive other drawings from these accompanying drawings without creative efforts.
FIG. 1A is a schematic diagram of a heat dissipation structure of a high-power cabinet in the prior art;
FIG. 1B is a schematic structural diagram of a heat exchange principle in the prior art;
FIG. 2A is a schematic structural diagram of a heat exchanger according to an embodiment of the present invention;
FIG. 2B is a schematic structural diagram of a heat exchanger according to an embodiment of the present invention;
FIG. 3 is a schematic structural diagram of a heat pipe heat exchanger system in a heat exchanger according to an embodiment of the present invention; and
FIG. 4 is a schematic structural diagram of an air conditioner system in a heat exchanger according to an embodiment of the present invention.

### DETAILED DESCRIPTION OF THE EMBODIMENTS

To make the objectives, technical solutions, and advantages of the present invention more comprehensible, the following further describes the present invention with reference to the accompanying drawings. Apparently, the embodiments to be described are merely a part rather than all of the embodiments of the present invention. All other embodiments obtained by persons of ordinary skill in the art based on the embodiments of the present invention without creative efforts shall fall within the protection scope of the present invention. It should be noted that, the "first", "second", "third" and "fourth" in the embodiments of the present invention are only intended to distinguish components of the same function or structure, and shall not be construed as a limitation to the embodiments of the present invention.

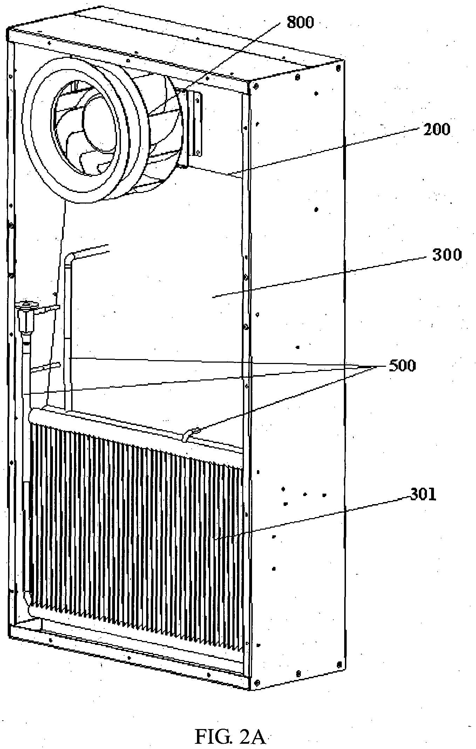

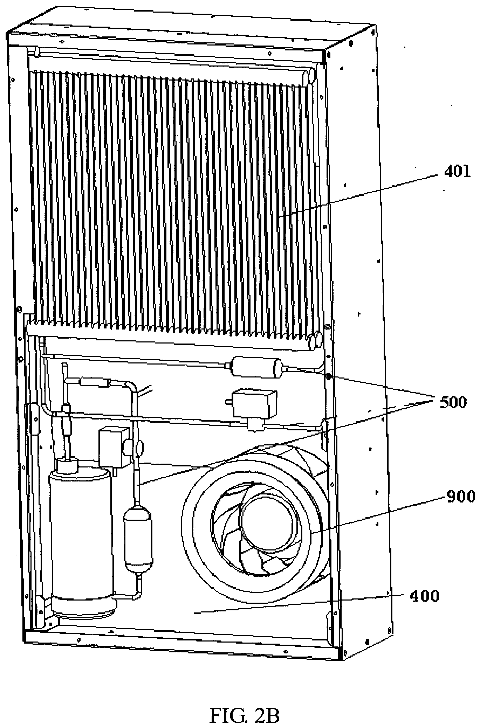

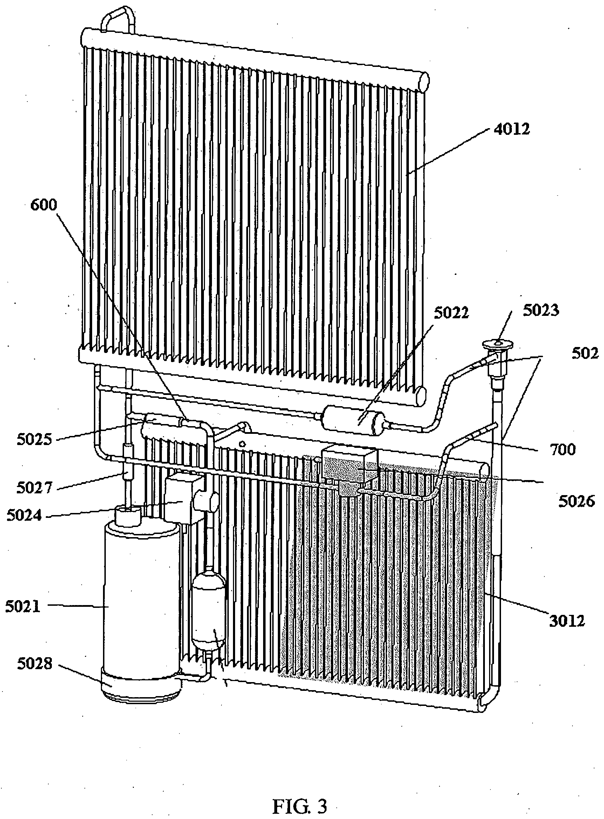

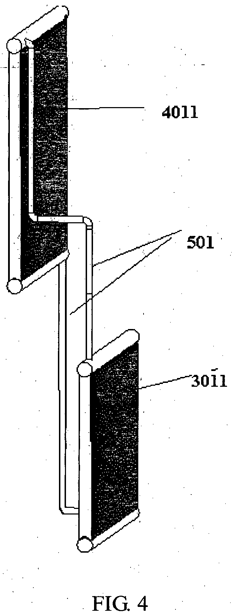

An embodiment of the present invention provides a heat exchanger. As shown in FIG. 2A and FIG. 2B and together with reference to FIG. 3 and FIG. 4, the heat exchanger includes:
a first air duct 300 and a second air duct 400, where the first air duct 300 and the second air duct 400 are isolated from each other, the first air duct 300 is set with a first heat exchange unit 301, the second air duct is set with a second heat exchange unit 401, and the first air duct 300 and the second air duct 400 may be isolated by adopting a partition board 200;
the first heat exchange unit 301 includes: a first heat pipe heat exchanger 3011 and an evaporative cooler 3012; and the second heat exchange unit 401 includes: a second heat pipe heat exchanger 4011 and a condensation radiator 4012;
a cavity of the first heat pipe heat exchanger 3011 is connected to a cavity of the second heat pipe heat exchanger 4011 through a first pipeline 501, so that a first closed loop is formed between the cavity of the first heat pipe heat exchanger 3011 and the cavity of the second heat pipe heat exchanger 4011;
a cavity of the evaporative cooler 3012 is connected to a cavity of the condensation radiator 4012 through a second pipeline 502, so that a second closed loop is formed between the cavity of the evaporative cooler 3012 and the cavity of the condensation radiator 4012; and
the first closed loop and the second closed loop each contain a fluid capable of carrying heat; and
the heat exchanger further includes: a compressor 5021 and a first valve 5024, where
the compressor 5021 is set in the second pipeline 502 through which the fluid flows from the evaporative cooler 3012 to the condensation radiator 4012, an inlet of the compressor 5021 is connected to the evaporative cooler 3012 through the second pipeline 502, and an outlet of the compressor 5021 is connected to the condensation radiator 4012 through the second pipeline 502; and the first valve 5024 is set in the second pipeline 502 between the inlet of the compressor 5021 and the evaporative cooler 3012; and
when the temperature of the first heat pipe heat exchanger 3011 side is higher than a first target temperature, the first valve 5024 is opened, and the compressor 5021 is turned on so that the compressor 5021 is in a working state; when the temperature of the first heat pipe heat exchanger 3011 side is lower than a second target temperature, the first valve 5024 is closed and the compressor 5021 is turned off so that the compressor 5021 is in an non-working state, where both the first target temperature and the second target temperature are lower than or equal to an ambient temperature needed by a heat source to work normally, and the first target temperature is higher than or equal to the second target temperature.

In this embodiment, the partition board 200 is adopted to isolate the two air ducts, and the heat exchange units are used in the air ducts so that enhanced heat dissipation may be performed on the air flowing through the air ducts, thereby improving heat exchange efficiency. In addition, it should be noted that, there may be multiple pipelines 500 between the first heat exchange unit 301 and the second heat exchange unit 401, and in use, some of the pipelines 500 are used as backflow pipelines while some are used as phase change working substances or refrigerant ascending pipelines. The specific number of the pipelines is not limited in the embodiment of the present invention. In the foregoing embodiment, when an actual control temperature is higher than the target temperature, the first valve is opened so that the compressor is in a working state, to implement enhanced heat dissipation; and when a actual control temperature is lower than the second target temperature, the first valve is closed so that the compressor is in an non-working state, and at this time, the heat pipe heat exchanger is still in a working state and also achieves desired heat dissipation capability. Therefore, with the technical solutions of the embodiments of the present invention, hierarchical heat dissipation can be implemented to meet heat dissipation requirements of different intensities, and in the condition that the heat dissipation capability is ensured, the compressor is turned off, which may reduce the working time of the compressor, thereby reducing power consumption to save energy, and reducing consumption of the compressor to prolong the service life of the heat exchanger.

In the embodiment of the present invention, a combined heat exchanger may be used in a cabinet, where a separated gravity heat pipe heat exchanger is integrated with a communication cabinet air conditioner system to implement the hierarchical heat dissipation, and a cabinet device uses a heat exchanger under a low load while uses an air conditioner under a high load. Compared with the case in which the air conditioner is merely used, power consumption is reduced greatly, and energy is saved. The time of using the air conditioner is reduced, thereby prolonging the service life of the air conditioner, and improving the overall reliability of the air conditioner.

Optionally, the closed loop between the sealed cavity of the first heat pipe heat exchanger 3011 and the sealed cavity of the second heat pipe heat exchanger 4011 is filled with a phase change working substance; and the closed loop between the sealed cavity of the evaporative cooler 3012 and the sealed cavity of the condensation radiator 4012 is filled with a refrigerant.

Furthermore, the second pipeline 502 where the compressor 5021 is located is further set with a first by-pass pipeline 600, and the second pipeline 502 is in parallel with the first by-pass pipeline 600; and
the first by-pass pipeline 600 is set with a second valve 5025, where the second valve 5025 is a valve having a function of allowing only one-way flowing of the fluid from the evaporative cooler 3012 to the condensation radiator 4012.

Furthermore, the second pipeline 502 between the outlet of the compressor 5021 and the condensation radiator 4012 is further set with a fourth valve 5027, where the fourth valve 5027 is a valve having a function of allowing only one-way flowing of the fluid from the compressor 5021 to the condensation radiator 4012.

Furthermore, the heat exchanger further includes:
a filter dryer 5022 and a cut-off apparatus 5023, where the cut-off apparatus 5023 is configured to limit the volume of the fluid flowing through the cut-off apparatus 5023, and may be an expansion valve or a capillary tube; and the filter dryer 5022 is configured to dry the fluid flowing through the filter dryer 5022; and
the second pipeline 502 through which the fluid in the condensation radiator 4012 flows to the evaporative cooler 3012 is installed with the filter dryer 5022, and the second pipeline 502 between the filter dryer 5022 and the evaporative cooler 3012 is installed with the cut-off apparatus 5023.

Furthermore, the first pipeline 501 through which the fluid in the condensation radiator 4012 flows back to the evaporative cooler 3012 is set with a second by-pass 700 at one side; and the first pipeline 501 through which the fluid in the condensation radiator 4012 flows back to the evaporative cooler 3012 is in parallel with the second by-pass 700, where
the second by-pass 700 is set with a third valve 5026; and
when the first valve 5024 is closed, the third valve 5026 is opened, and when the first valve 5024 is opened, the third valve 5026 is closed.

Furthermore, the heat exchanger further includes that:
the compressor 5021 is set with a heating band 5028 at the bottom; and
the heating band 5028 is turned on when the temperature of the environment where the heat exchanger is located is lower than a preset value, so as to heat the compressor 5021, where the preset value is higher than or equal to a lowest temperature needed by the fluid in the second closed loop to aggregate to the compressor.

Optionally, the first closed loop is filled with a phase change working substance; and the fluid in the second closed loop is a refrigerant.

Optionally, an inlet of the first heat pipe heat exchanger 3011 is located at its top end and an outlet located at its bottom end; and an inlet of the second heat pipe heat exchanger 4011 is located at its bottom end and an outlet located at its top end; and
an inlet of the evaporative cooler 3012 is located at its top end and an outlet located at its bottom end; and an inlet of the condensation radiator 4012 is located at its bottom end and an outlet located at its top end.

The specific implementation of the above solution is described in detail in the following embodiment, and a communication base station is taken as an example for illustration in this embodiment. It should not be understood that the heat exchanger can only applied to the communication base station, so the communication base station should not be construed as a limitation to the embodiment of the present invention.

A combined heat dissipation apparatus is used in a communication base station cabinet, where a separated gravity heat pipe heat exchanger system is integrated with a communication cabinet air conditioner system, and the two systems may run individually or run cooperatively, which may be described in the subsequence embodiment. The two systems each are divided into an internal circulation air duct (the first air duct 300) and an external circulation air duct (the second air duct 300) by the partition board 200.

A fan 800 and the first heat exchange unit 301 are in the internal circulation air duct (the first air duct 300) (the first air duct 300). The air flows through the first heat exchange unit 301 and is then blown by the fan 800 into the cabinet, so as to cool a communication device. A fan 900 and the second heat exchange unit 401 are in the external circulation air duct (the second air duct 300). The air flows through the second heat exchange unit 401 and is then exhausted by the fan 900, so as to take away heat generated by the communication device.

The first heat exchange unit 301 may be formed by the first heat pipe heat exchanger 3011 used in the separated gravity heat pipe heat exchanger system and the evaporative cooler 3012 used in the communication cabinet air conditioner system, where the two may be fixed together by a sideboard to form an integral unit, the two are not in communication and are separate from each other, and the positions of the two are interchangeable. It should be noted that other fixing manners may also be adopted, which are not limited in the embodiment of the present invention.

The second heat exchange unit 401 may be formed by the second heat pipe heat exchanger 4011 used in the separated gravity heat pipe heat exchanger system and the condensation radiator 4012 used in the communication cabinet air conditioner system, where the two are fixed together by a common sideboard 14, the two may be fixed together by a sideboard to form an integral unit, the two are not in communication and are separate from each other, and the positions of the two are interchangeable. It should be noted that other fixing manners may also be adopted, which are not limited in the embodiment of the present invention.

The separated gravity heat pipe heat exchanger system includes: the first heat pipe heat exchanger 3011 in the first heat exchange unit 301 and the second heat pipe heat exchanger 4011 in the second heat exchange unit 401, being in communication through a vapor ascending pipe and a liquid descending pipe, so as to form a closed loop filled with a refrigerant.

The first heat pipe heat exchanger 3011 in the first heat exchange unit 301 is located in the internal circulation air duct (the first air duct 300), and the fan 800 drives an internal hot airflow to flow through the first heat pipe heat exchanger 3011, to implement heat exchange between the phase change working substance in the first heat pipe heat exchanger 3011 and the hot air. The second heat pipe heat exchanger 4011 in the second heat exchange unit 401 is located in the external circulation air duct (the second air duct 400), and the fan 900 drives an external cold airflow to flow through the second heat pipe heat exchanger 4011, to implement heat exchange between the phase change working substance in the condensation radiator 4012 and the cold air. The phase change working substance is vaporized after absorbing heat in the first heat pipe heat exchanger 3011, and reaches the second heat pipe heat exchanger 4011 through the vapor ascending pipe; and the phase change working substance is condensed after releasing heat in the second heat pipe heat exchanger 4011, and reaches the first heat pipe heat exchanger 3011 through the liquid descending pipe, to complete a cycle.

In the communication cabinet air conditioner system, the evaporative cooler 3012 in the first heat exchange unit 301, the condensation radiator 4012 in the second heat exchange unit 401, the compressor 5021, the filter dryer 5022, the cut-off apparatus 5023 (which may be an expansion valve or a capillary tube), and the second pipeline 502 may form a closed loop filled with a refrigerant.

The phase change working substance absorbs the heat of an object (hot air in the cabinet) to be cooled, and is vaporized in the evaporative cooler 3012 in the first heat exchange unit 301. The formed low-pressure vapor enters the compressor 5021 through the second pipeline 502 and is compressed into high-pressure vapor. The high-pressure vapor then enters the condensation radiator 4012 in the second heat exchange unit 401 through the second pipeline 502 and is cooled by normal temperature cooling air to be condensed into a high-pressure liquid. The high-pressure liquid becomes in a low-pressure and low-temperature state after flowing through the filter dryer 5022 and the cut-off apparatus 5023, and enters the evaporative cooler 3012. In this way, continuous refrigeration is implemented in cycles.

When a cabinet communication device releases a large amount of heat, the communication cabinet air conditioner system is turned on, and the separated gravity heat pipe heat exchanger system is turned off, so as to perform refrigeration; and when the cabinet communication device does not release a large amount of heat, the separated gravity heat pipe heat exchanger system is turned on, and the communication cabinet air conditioner system is turned off, so as to perform heat dissipation.

The central position of the second heat exchange unit 401 is higher than the central position of the first heat exchange unit 301, the first heat exchange unit unit 301 and the second heat exchange unit 401 each may be formed by one or more copper pipe finned type heat exchangers or parallel flow micro-channel type heat exchangers, and there may be one or more vapor ascending pipes and there may be one or more liquid descending pipes.

The phase change working substance in the heat exchanger may be the freon 134A (tetrafluoroethane, R134A, chemical formula: CH2FCF3).

The fan 800 and the fan 900 each may be an axial flow fan or a centrifugal fan. The specific type of the fan to be used is not limited in the embodiment of the present invention, and the exemplification of the two fans should not be construed as a limitation to the embodiment of the present invention.

An embodiment of the present invention further describes a working principle where the separated gravity heat pipe heat exchanger system and the communication cabinet air conditioner system work individually or work cooperatively. In this embodiment based on the foregoing embodiment, a by-pass pipeline is added to the communication cabinet air conditioner system, and a valve (which may be a one-way valve, an electromagnetic valve, an electric ball valve or the like) is added to the by-pass pipeline, to control the by-pass pipeline to be opened or closed, so that the system can switch between a separated gravity heat pipe heat exchanger and a communication cabinet air conditioner.

In the communication cabinet air conditioner system, the first by-pass pipeline 600 and the second by-pass pipeline 700 are installed at the compressor 5021 and the cut-off apparatus 5023 (which may be an expansion valve or a capillary tube), respectively, the second valve 5025 is added on the first by-pass pipeline 600, the first valve 5024 is added in front of the inlet of the compressor 5021, the fourth valve 5027 is added at the outlet of the compressor 5021, and the third valve 5026 is added on the second by-pass pipeline 700. A specific structure is shown in FIG. 3.

When the third valve 5026 is opened and the first valve 5024 is closed, the system is in a separated gravity heat pipe heat exchanger mode. The first valve 5024 and the third valve 5026 may be electromagnetic valves, and the second valve 5025 and the fourth valve 5027 may be one-way valves, where a one-way valve is an apparatus in which the fluid can only flow along an inlet, and the substance at an outlet cannot flow back, so as to control the one-way flowing of the fluid.

When the third valve 5026 is closed and the first valve 5024 is opened, the system is in a communication cabinet air conditioner mode.

When a cabinet communication device releases a large amount of heat, a communication cabinet air conditioner mode is started, and a separated gravity heat pipe heat exchanger is turned off, to perform heat dissipation; and when the cabinet communication device does not release a large amount of heat, a separated gravity heat pipe heat exchanger is turned on, and a communication cabinet air conditioner mode is terminated, to perform heat dissipation.

After the air conditioner mode is switched to the separated gravity heat pipe heat exchanger mode, the first valve 5024 at the air inlet of the compressor 5021 and the fourth valve 5027 at the air outlet of the compressor 5021 can prevent the phase change working substance from aggregating to the compressor 5021, and avoid a liquid strike formed when the compressor 5021 is started again.

A heating band 5028 is set at the bottom of the compressor 5021, where the heating band 5028 may be an electrical heating band. In a low-temperature case, the heating band 5028 is turned on to keep a certain temperature, thereby preventing the phase change working substance from aggregating to the compressor 5021, and avoiding a liquid strike formed when the compressor 5021 is started again.

In the embodiment of the present invention, a combined heat exchanger may be used in a cabinet, where a separated gravity heat pipe heat exchanger is integrated with a communication cabinet air conditioner system to implement hierarchical heat dissipation, and a cabinet device uses a heat exchanger under a low load while uses an air conditioner under a high load. Compared with the case in which the air conditioner is merely used, power consumption is reduced greatly, and energy is saved. The time of using the air conditioner is reduced, thereby prolonging the service life of the air conditioner, and improving the overall reliability of the air conditioner.

An embodiment of the present invention further provides a cabinet. Referring to FIG. 2A and FIG. 2B, the cabinet includes: an internal side of the cabinet and an external side of the cabinet, where the internal side of the cabinet is a side installed with a heat source component, and the external side of the cabinet is space outside the cabinet; and further includes: any heat exchanger provided by the embodiments of the present invention, where the first air duct 300 of the heat exchanger is located at the internal side of the cabinet, the second air duct 400 is located at the external side of the cabinet, and the first heat exchange unit 301 of the heat exchanger is located below the second heat exchange unit 401. Reference may be made to the foregoing embodiments of the heat exchanger for the principle and usage of the cabinet.

In the embodiment of the present invention, a combined heat exchanger may be used in the cabinet, where a separated gravity heat pipe heat exchanger is integrated with a communication cabinet air conditioner system to implement hierarchical heat dissipation, and a cabinet device uses a heat exchanger under a low load while uses an air conditioner under a high load. Compared with the case in which the air conditioner is merely used, power consumption is reduced greatly, and energy is saved. The time of using the air conditioner is reduced, thereby prolonging the service life of the air conditioner, and improving the overall reliability of the air conditioner.

It should be noted that, the foregoing description is merely about the specific exemplary embodiments of the present invention, but is not intended to limit the protection scope of the present invention. Any variation or replacement figured out by persons skilled in the art within the technical scope disclosed in the embodiments of the present invention shall fall within the protection scope of the present invention. Therefore, the protection scope of the present invention shall be subject to the protection scope of the claims.

## Claims

1. A heat exchanger, comprising: a first air duct (300) and a second air duct (400), wherein the first air duct (300) and the second air duct (400) are isolated from each other, the first air duct (300) is set with a first heat exchange unit (301), and the second air duct (400) is set with a second heat exchange unit (401); **characterized in that**:
the first heat exchange unit (301) comprises: a first heat pipe heat exchanger (3011) and an evaporative cooler (3012); and the second heat exchange unit (401) comprises: a second heat pipe heat exchanger (4011) and a condensation radiator (4012);
a cavity of the first heat pipe heat exchanger (3011) is connected to a cavity of the second heat pipe heat exchanger (4011) through a first pipeline (501), so that a first closed loop is formed between the cavity of the first heat pipe heat exchanger (3011) and the cavity of the second heat pipe heat exchanger (4011);
a cavity of the evaporative cooler (3012) is connected to a cavity of the condensation radiator (4012) through a second pipeline (502), so that a second closed loop is formed between the cavity of the evaporative cooler (3012) and the cavity of the condensation radiator (4012); and
the first closed loop and the second closed loop each contain a fluid capable of carrying heat; and
**characterized in that**, the heat exchanger further comprises: a compressor (5021) and a first valve (5024), wherein
the compressor (5021) is set in the second pipeline (502) through which the fluid flows from the evaporative cooler (3012) to the condensation radiator (4012), an inlet of the compressor (5021) is connected to the evaporative cooler (3012) through the second pipeline (502), and an outlet of the compressor (5021) is connected to the condensation radiator (4012) through the second pipeline (502); and the first valve (5024) is set in the second pipeline (502) between the inlet of the compressor (5021) and the evaporative cooler (3012); and
when the temperature of the first heat pipe heat exchanger (3011) side is higher than a first target temperature, the first valve (5024) is opened, and the compressor (5021) is turned on so that the compressor (5021) is in a working state; when the temperature of the first heat pipe heat exchanger (3011) side is lower than a second target temperature, the first valve (5024) is closed, and the compressor (5021) is turned off so that the compressor (5021) is in a non-working state, wherein both the first target temperature and the second target temperature are lower than or equal to an ambient temperature needed by a heat source to work normally, and the first target temperature is higher than or equal to the second target temperature.

2. The heat exchanger according to claim 1, wherein the second pipeline (502) where the compressor (5021) is located is further set with a first by-pass pipeline (600), and the second pipeline (502) is in parallel with the first by-pass pipeline (600); and
the first by-pass pipeline (600) is set with a second valve (5025), and the second valve (5025) is a valve having a function of allowing only one-way flowing of the fluid from the evaporative cooler (3012) to the condensation radiator (4012).

3. The heat exchanger according to claim 1, wherein
the second pipeline (502) between the outlet of the compressor (5021) and the condensation radiator (4012) is further set with a fourth valve (5027), and the fourth valve (5027) is a valve having a function of allowing only one-way flowing of the fluid from the compressor (5021) to the condensation radiator (4012).

4. The heat exchanger according to claim 1, further comprising:
a filter dryer (5022) and a cut-off apparatus (5023), wherein
the second pipeline (502) through which the fluid in the condensation radiator (4012) flows to the evaporative cooler (3012) is installed with the filter dryer (5022), and the second pipeline (502) between the filter dryer (5022) and the evaporative cooler (3012) is installed with the cut-off apparatus (5023); and
the filter dryer (5022) is configured to dry the fluid flowing through the filter dryer (5022); and the cut-off apparatus (5023) is configured to limit a volume of the fluid flowing through the cut-off apparatus (5023).

5. The heat exchanger according to claim 4, wherein the second pipeline (502) through which the fluid in the condensation radiator (4012) flows back to the evaporative cooler (3012) is set with a second by-pass pipeline (700) at one side; and the second pipeline (502) through which the fluid in the condensation radiator (4012) flows back to the evaporative cooler (3012) is in parallel with the second by-pass pipeline (700);
the second by-pass pipeline (700) is set with a third valve (5026); and
when the first valve (5024) is closed, the third valve (5026) is opened, and when the first valve (5024) is opened, the third valve (5026) is closed.

6. The heat exchanger according to claim 1, wherein
the compressor (5021) is set with a heating band (5028) at the bottom; and the heating band (5028) is turned on when a temperature of an environment where the heat exchanger is located is lower than a preset value, so as to heat the compressor (5021), wherein the preset value is higher than or equal to a lowest temperature needed by the fluid in the second closed loop to aggregate to the compressor (5021).

7. The heat exchanger according to any one of claims 1 to 6, wherein
the first closed loop is filled with a phase change working substance.

8. The heat exchanger according to any one of claims 1 to 6, wherein
the fluid in the second closed loop is a refrigerant.

9. The heat exchanger according to any one of claims 1 to 6, wherein
an inlet of the first heat pipe heat exchanger (3011) is located at its top end and an outlet is located at its bottom end; and an inlet of the second heat pipe heat exchanger (4011) is located at its bottom end and an outlet is located at its top end; and
an inlet of the evaporative cooler (3012) is located at its top end and an outlet is located at its bottom end; and an inlet of the condensation radiator (4012) is located at its bottom end and an outlet is located at its top end.

10. A cabinet, comprising: an internal side of the cabinet and an external side of the cabinet, wherein the internal side of the cabinet is a side installed with a heat source component, and the external side of the cabinet is space outside the cabinet; **characterized in that** the cabinet further comprises: the heat exchanger according to any one of claims 1 to 9, wherein the first air duct (300) of the heat exchanger is located at the internal side of the cabinet, the second air duct (400) is located at the external side of the cabinet, and the first heat exchange unit (301) of the heat exchanger is located below the second heat exchange unit (401).

## Patentansprüche

1. Wärmetauscher, umfassend: einen ersten Luftkanal (300) und einen zweiten Luftkanal (400), wobei der erste Luftkanal (300) und der zweite Luftkanal (400) voneinander getrennt sind, der erste Luftkanal (300) mit einer ersten Wärmetauscheinheit (301) versehen ist und der zweite Luftkanal (400) mit einer zweiten Wärmetauscheinheit (401) versehen ist; **dadurch gekennzeichnet, dass**:
die erste Wärmetauscheinheit (301) umfasst: einen ersten Wärmerohr-Wärmetauscher (3011) und einen Verdampfungskühler (3012); und die zweite Wärmetauscheinheit (401) umfasst: einen zweiten Wärmerohr-Wärmetauscher (4011) und einen Kondensationsradiator (4012);
ein Hohlraum des ersten Wärmerohr-Wärmetauschers (3011) durch eine erste Rohrleitung (501) mit einem Hohlraum des zweiten Wärmerohr-Wärmetauschers (4011) derart verbunden ist, dass zwischen dem Hohlraum des ersten Wärmerohr-Wärmetauschers (3011) und dem Hohlraum des zweiten Wärmerohr-Wärmetauschers (4011) ein erster geschlossener Kreis gebildet wird;
ein Hohlraum des Verdampfungskühlers (3012) durch eine zweite Rohrleitung (502) mit einem Hohlraum des Kondensationsradiators (4012) derart verbunden ist, dass zwischen dem Hohlraum des Verdampfungskühlers (3012) und dem Hohlraum des Kondensationsradiators (4012) ein zweiter geschlossener Kreis gebildet wird; und
der erste geschlossene Kreis und der zweite geschlossene Kreis jeweils ein Fluid enthalten, das in der Lage ist, Wärme zu transportieren; und
**dadurch gekennzeichnet, dass** der Wärmetauscher ferner umfasst: einen Verdichter (5021) und ein erstes Ventil (5024), wobei
der Verdichter (5021) in der zweiten Rohrleitung (502) angeordnet ist, durch welche das Fluid von dem Verdampfungskühler (3012) zu dem Kondensationsradiator (4012) strömt, ein Einlass des Verdichters (5021) durch die zweite Rohrleitung (502) mit dem Verdampfungskühler (3012) verbunden ist und ein Auslass des Verdichters (5021) durch die zweite Rohrleitung (502) mit dem Kondensationsradiator (4012) verbunden ist; und das erste Ventil (5024) zwischen dem Einlass des Verdichters (5021) und dem Verdampfungskühler (3012) in der zweiten Rohrleitung (502) angeordnet ist; und,
wenn die Temperatur der Seite des ersten Wärmerohr-Wärmetauschers (3011) höher als eine erste Solltemperatur ist, das erste Ventil (5024) geöffnet wird und der Verdichter (5021) eingeschaltet wird, so dass sich der Verdichter (5021) in einem Arbeitszustand befindet; wenn die Temperatur der Seite des ersten Wärmerohr-Wärmetauschers (3011) niedriger als eine zweite Solltemperatur ist, das erste Ventil (5024) geschlossen wird und der Verdichter (5021) ausgeschaltet wird, so dass sich der Verdichter (5021) in einem Nichtarbeitszustand befindet, wobei sowohl die erste Solltemperatur als auch die zweite Solltemperatur kleiner gleich einer Umgebungstemperatur ist, die erforderlich ist, damit eine Wärmequelle normal funktionieren kann, und die erste Solltemperatur größer gleich der zweiten Solltemperatur ist.

2. Wärmetauscher nach Anspruch 1, wobei die zweite Rohrleitung (502), wo der Verdichter (5021) angeordnet ist, ferner mit einer ersten Bypass-Rohrleitung (600) versehen ist, und die zweite Rohrleitung (502) zu der ersten Bypass-Rohrleitung (600) parallel ist; und
die erste Bypass-Rohrleitung (600) mit einem zweiten Ventil (5025) versehen ist und das zweite Ventil (5025) ein Ventil mit einer Funktion, das Strömen des Fluids von dem Verdampfungskühler (3012) zu dem Kondensationsradiator (4012) nur in eine Richtung zu gestatten, ist.

3. Wärmetauscher nach Anspruch 1, wobei
die zweite Rohrleitung (502) zwischen dem Auslass des Kompressors (5021) und dem Kondensationsradiator (4012) ferner mit einem vierten Ventil (5027) versehen ist, und das vierte Ventil (5027) ein Ventil mit einer Funktion, das Strömen des Fluids von dem Verdichter (5021) zu dem Kondensationsradiator (4012) nur in eine Richtung zu gestatten, ist.

4. Wärmetauscher nach Anspruch 1, ferner umfassend:
einen Filtertrockner (5022) und eine Absperrvorrichtung (5023), wobei die zweite Rohrleitung (502), durch welche das Fluid in dem Kondensationsradiator (4012) zu dem Verdampfungskühler (3012) strömt, mit dem Filtertrockner (5022) angebracht ist und die zweite Rohrleitung (502) zwischen dem Filtertrockner (5022) und dem Verdampfungskühler (3012) mit der Absperrvorrichtung (5023) angebracht ist; und
der Filtertrockner (5022) dazu ausgebildet ist, das Fluid, welches durch den Filtertrockner (5022) strömt, zu trocknen; und die Absperrvorrichtung (5023) dazu ausgebildet ist, eine Menge des Fluids, welche durch die Absperrvorrichtung (5023) strömt, zu begrenzen.

5. Wärmetauscher nach Anspruch 4, wobei die zweite Rohrleitung (502), durch welche das Fluid in dem Kondensationsradiator (4012) zu dem Verdampfungskühler (3012) zurückströmt, auf einer Seite mit einer zweiten Bypass-Rohrleitung (700) versehen ist; und die zweite Rohrleitung (502), durch welche das Fluid in dem Kondensationsradiator (4012) zu dem Verdampfungskühler (3012) zurückströmt, zu der zweiten Bypass-Rohrleitung (700) parallel ist;
die zweite Bypass-Rohrleitung (700) mit einem dritten Ventil (5026) versehen ist; und,
wenn das erste Ventil (5024) geschlossen ist, das dritte Ventil (5026) geöffnet ist, und wenn das erste Ventil (5024) geöffnet ist, das dritte Ventil (5026) geschlossen ist.

6. Wärmetauscher nach Anspruch 1, wobei
der Verdichter (5021) am unteren Ende mit einem Heizband (5028) versehen ist; und das Heizband (5028) eingeschaltet wird, wenn eine Temperatur einer Umgebung, wo der Wärmetauscher angeordnet ist, niedriger als ein voreingestellter Wert ist, um den Verdichter (5021) zu erwärmen, wobei der voreingestellte Wert größer gleich einer niedrigsten Temperatur ist, die erforderlich ist, damit sich das Fluid in dem zweiten geschlossenen Kreis an dem Verdichter (5021) ansammelt.

7. Wärmetauscher nach einem beliebigen der Ansprüche 1 bis 6, wobei der erste geschlossene Kreis mit einer Phasenwechsel-Arbeitssubstanz gefüllt ist.

8. Wärmetauscher nach einem beliebigen der Ansprüche 1 bis 6, wobei das Fluid in dem zweiten geschlossenen Kreis ein Kältemittel ist.

9. Wärmetauscher nach einem beliebigen der Ansprüche 1 bis 6, wobei ein Einlass des ersten Wärmerohr-Wärmetauschers (3011) an dessen oberem Ende angeordnet ist und ein Auslass an dessen unterem Ende angeordnet ist; und ein Einlass des zweiten Wärmerohr-Wärmetauschers (4011) an dessen unterem Ende angeordnet ist und ein Auslass an dessen oberem Ende angeordnet ist; und
ein Einlass des Verdampfungskühlers (3012) an dessen oberem Ende angeordnet ist und ein Auslass an dessen unterem Ende angeordnet ist; und ein Einlass des Kondensationsradiators (4012) an dessen unterem Ende angeordnet ist und ein Auslass an dessen oberem Ende angeordnet ist.

10. Schrank, umfassend: eine Innenseite des Schranks und eine Außenseite des Schranks, wobei die Innenseite des Schranks eine Seite ist, an der eine Wärmequellenkomponente angebracht ist, und die Außenseite des Schranks Raum außerhalb des Schranks ist; **dadurch gekennzeichnet, dass** der Schrank ferner umfasst:
den Wärmetauscher nach einem beliebigen der Ansprüche 1 bis 9, wobei der erste Luftkanal (300) des Wärmetauschers an der Innenseite des Schranks angeordnet ist, der zweite Luftkanal (400) an der Außenseite des Schranks angeordnet ist und die erste Wärmetauscheinheit (301) des Wärmetauschers unter der zweiten Wärmetauscheinheit (401) angeordnet ist.

## Revendications

1. Echangeur de chaleur, comprenant un premier conduit d'air (300) et un second conduit d'air (400), dans lequel le premier conduit d'air (300) et le second conduit d'air (400) sont isolés l'un de l'autre, le premier conduit d'air (300) est posé avec une première unité d'échange de chaleur (301) et le second conduit d'air (400) est posé avec une seconde unité d'échange de chaleur (401) ; **caractérisé en ce que** :
la première unité d'échange de chaleur (301) comprend : un premier échangeur de chaleur à caloducs (3011) et un refroidisseur à évaporation (3012) ; et la seconde unité d'échange de chaleur (401) comprend : un second échangeur de chaleur à caloducs (4011) et un radiateur à condensation (4012) ;
une cavité du premier échangeur de chaleur à caloducs (3011) est raccordée à une cavité du second échangeur de chaleur à caloducs (4011) au moyen d'une première canalisation (501) de telle sorte qu'une première boucle fermée soit formée entre la cavité du premier échangeur de chaleur à caloducs (3011) et la cavité du second échangeur de chaleur à caloducs (4011) ;
une cavité du refroidisseur à évaporation (3012) est raccordée à une cavité du radiateur à condensation (4012) au moyen d'une seconde canalisation (502) de telle sorte qu'une seconde boucle fermée soit formée entre la cavité du refroidisseur à évaporation (3012) et la cavité du radiateur à condensation (4012) ; et
la première boucle fermée et la seconde boucle fermée contiennent chacune un fluide qui peut transporter la chaleur ; et
**caractérisé en ce que** l'échangeur de chaleur comprend en outre : un compresseur (5021) et une première vanne (5024), dans lequel
le compresseur (5021) est posé dans la seconde canalisation (502) à travers laquelle le fluide s'écoule depuis le refroidisseur à évaporation (3012) jusqu'au radiateur à condensation (4012), un orifice d'entrée du compresseur (5021) est raccordé au refroidisseur à évaporation (3012) au moyen d'une seconde canalisation (502), et un orifice de sortie du compresseur (5021) est raccordé au radiateur à condensation (4012) au moyen de la seconde canalisation (502) ; et la première vanne (5024) est posée dans la seconde canalisation (502) entre l'orifice d'entrée du compresseur (5021) et le refroidisseur à évaporation (3012) ; et
lorsque la température côté premier échangeur de chaleur à caloducs (3011) est supérieure à une première température cible, la première vanne (5024) est ouverte et le compresseur (5021) est mis en marche de telle sorte que le compresseur (5021) soit dans un état de travail ; lorsque la température côté premier échangeur de chaleur à caloducs (3011) est inférieure à une seconde température cible, la première vanne (5024) est fermée et le compresseur (5021) est arrêté de telle sorte que le compresseur (5021) soit dans un état de repos ; dans lequel à la fois la première température cible et la seconde température cible sont inférieures ou égales à une température ambiante nécessitée par une source de chaleur pour travailler normalement et la première température cible est supérieure ou égale à la seconde température cible.

2. Echangeur de chaleur selon la revendication 1, dans lequel la seconde canalisation (502) dans laquelle le compresseur (5021) est placé, est en outre posée avec une première canalisation de dérivation (600) et la seconde canalisation (502) est parallèle à la première canalisation de dérivation (600) ; et
la première canalisation de dérivation (600) est posée avec une deuxième vanne (5025) et la deuxième vanne (5025) est une vanne ayant une fonction permettant seulement une circulation unidirectionnelle du fluide depuis le refroidisseur à évaporation (3012) jusqu'au radiateur à condensation (4012).

3. Echangeur de chaleur selon la revendication 1, dans lequel
la seconde canalisation (502) entre l'orifice de sortie du compresseur (5021) et le radiateur à condensation (4012) est en outre posée avec une quatrième vanne (5027) et la quatrième vanne (5027) est une vanne ayant une fonction permettant seulement une circulation unidirectionnelle du fluide depuis le compresseur (5021) jusqu'au radiateur à condensation (4012).

4. Echangeur de chaleur selon la revendication 1, comprenant en outre:
un déshydrateur-filtre (5022) et un appareil de coupure (5023), dans lequel la seconde canalisation (502) à travers laquelle le fluide dans le radiateur à condensation (4012) circule jusqu'au refroidisseur à évaporation (3012), est installée avec le déshydrateur-filtre (5022) et la seconde canalisation (502) entre le déshydrateur-filtre (5022) et le refroidisseur à évaporation (3012) est installée avec l'appareil de coupure (5023) ; et
le déshydrateur-filtre (5022) est configuré pour sécher le fluide circulant à travers le déshydrateur-filtre (5022) ; et l'appareil de coupure (5023) est configuré pour limiter un volume du fluide circulant à travers l'appareil de limitation (5023).

5. Echangeur de chaleur selon la revendication 4, dans lequel la seconde canalisation (502) à travers laquelle le fluide dans le radiateur à condensation (4012) reflue vers le refroidisseur à évaporation (3012), est posée avec une seconde canalisation de dérivation (700) sur un côté ; et la seconde canalisation (502) à travers laquelle le fluide dans le radiateur à condensation (4012) reflue vers le refroidisseur à évaporation (3012), est parallèle à la seconde canalisation de dérivation (700) ;
la seconde canalisation de dérivation (700) est posée avec une troisième vanne (5026); et
lorsque la première vanne (5024) est fermée, la troisième vanne (5026) est ouverte et, lorsque la première vanne (5024) est ouverte, la troisième vanne (5026) est fermée.

6. Echangeur de chaleur selon la revendication 1, dans lequel
le compresseur (5021) est posé avec une bande chauffante (5028) sur la partie inférieure ; et
la bande chauffante (5028) est alimentée lorsqu'une température d'un environnement dans lequel l'échangeur de chaleur est placé, est inférieure à une valeur prédéterminée de sorte à chauffer le compresseur (5021), dans lequel la valeur prédéterminée est supérieure ou égale à la température la plus basse nécessaire pour que le fluide dans la seconde boucle fermée s'agrège au compresseur (5021).

7. Echangeur de chaleur selon l'une quelconque des revendications 1 à 6, dans lequel la première boucle fermée est remplie d'une substance de travail à changement de phase.

8. Echangeur de chaleur selon l'une quelconque des revendications 1 à 6, dans lequel le fluide dans la seconde boucle fermée est un fluide frigorigène.

9. Echangeur de chaleur selon l'une quelconque des revendications 1 à 6, dans lequel un orifice d'entrée du premier échangeur de chaleur à caloducs (3011) est situé au niveau de son extrémité supérieure et un orifice de sortie est situé au niveau de son extrémité inférieure ; et un orifice d'entrée du second échangeur de chaleur à caloducs (4011) est situé au niveau de son extrémité inférieure et un orifice de sortie est situé au niveau de son extrémité supérieure ;
un orifice d'entrée du refroidisseur à évaporation (3012) est situé au niveau de son extrémité supérieure et un orifice de sortie est situé au niveau de son extrémité inférieure ; et un orifice d'entrée du radiateur à condensation (4012) est situé au niveau de son extrémité inférieure et un orifice de sortie est situé au niveau de son extrémité supérieure.

10. Armoire, comprenant : un côté interne de l'armoire et un côté externe de l'armoire, dans laquelle le côté interne de l'armoire est un côté installé avec un composant de source de chaleur et le côté externe de l'armoire est un espace à l'extérieur de l'armoire ; **caractérisée en ce que** l'armoire comprend en outre : l'échangeur de chaleur selon l'une quelconque des revendications 1 à 9, dans laquelle le premier conduit d'air (300) de l'échangeur de chaleur est situé au niveau du côté interne de l'armoire, le second conduit d'air (400) est situé au niveau du côté externe de l'armoire et la première unité d'échange de chaleur (301) de l'échangeur de chaleur est située en dessous de la seconde unité d'échange de chaleur (401).
